# EUROPÄISCHE PATENTSCHRIFT

(11) **EP 2 798 361 B1**
(45) Veröffentlichungstag und Bekanntmachung des Hinweises auf die Patenterteilung: **17.10.2018**
(21) Anmeldenummer: 12735507.1
(22) Anmeldetag: 09.07.2012
(51) Int. Cl.: G01R 1/20, G01R 19/00, G01R 19/165, H01M 10/0525, H01M 10/48, G01R 31/36

(54) **VORRICHTUNG UND VERFAHREN ZUR MESSUNG EINER MINIMALEN ZELLSPANNUNG**
DEVICE AND METHOD FOR MEASURING A MINIMUM CELL VOLTAGE
DISPOSITIF ET PROCÉDÉ PERMETTANT DE MESURER LA TENSION MINIMALE D'UN ÉLÉMENT

(30) Priorität: 19.07.2011 DE 102011079363
(43) Veröffentlichungstag der Anmeldung: 05.11.2014
(73) Patentinhaber: Robert Bosch GmbH, 70442 Stuttgart (DE); SAMSUNG SDI CO., LTD., Yongin-si, Gyeonggi-do 446-577 (KR)
(72) Erfinder: BUTZMANN, Stefan, 71717 Beilstein (DE)
(74) Vertreter: Ketterle, Karl Michael
(86) Internationale Anmeldenummer: PCT/EP2012/063382
(87) Internationale Veröffentlichungsnummer: WO 2013/010843

(56) Entgegenhaltungen:
- DE-A1-102008 043 921
- US-A1- 2009 130 542
- US-A1- 2010 239 896

## Beschreibung

Die vorliegende Erfindung betrifft eine Vorrichtung und ein Verfahren zur Messung der minimalen Zellspannung unter den Zellspannungen einer Vielzahl von in Reihe geschalteten Batteriezellen sowie eine Batteriemanagementeinheit mit einer solchen Vorrichtung, eine Batterie mit einer solchen Vorrichtung oder einer solchen Batteriemanagementeinheit sowie ein Kraftfahrzeug mit einer solchen Batterie.

### Stand der Technik

Es zeichnet sich ab, dass in Zukunft sowohl bei stationären Anwendungen (zum Beispiel bei Windkraftanlagen) als auch in Fahrzeugen wie Hybrid- und Elektrofahrzeugen vermehrt neue Batteriesysteme zum Einsatz kommen werden, an die sehr hohe Anforderungen bezüglich Zuverlässigkeit gestellt werden. Hintergrund für diese hohen Anforderungen ist, dass ein Ausfall der Batterie zu einem Ausfall des Gesamtsystems oder sogar zu einem sicherheitsrelevanten Problem führen kann. So werden beispielsweise bei Windkraftanlagen Batterien eingesetzt, um bei starkem Wind die Anlage durch eine Rotorblattverstellung vor unzulässigen Betriebszuständen zu schützen.

Üblicherweise wird heute bei Lithium-Ionen-Batterien die Spannung jeder Zelle einzeln überwacht, um diese vor Tiefentladung schützen zu können. Dazu dient typischerweise eine spezifische integrierte Schaltung mit Multiplexer und Analog/Digital-Wandler, die in Kommunikation mit einer Steuereinheit steht. Diese Lösung ist aufwendig und teuer.

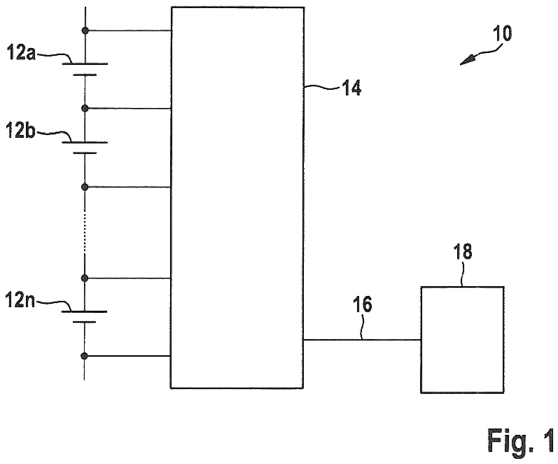

Figur 1 zeigt das Prinzip einer solchen Einzelüberwachung gemäß dem Stand der Technik. Eine Batteriemanagementeinheit 10 umfasst eine integrierte Schaltung 14, die mit jeder der Batteriezellen 12a, 12b, ..., 12n einer Batterie elektrisch verbunden ist. Die integrierte Schaltung 14 umfasst einen Multiplexer und einen Analog/Digital-Wandler und ist über einen Kommunikations-Bus 16 mit einer Steuereinheit 18 verbunden.

Aus der DE 10 2008 043 921 A1 ist eine Vorrichtung für elektrische Zellspannungsmessungen bekannt, in der jede Speicherzelle eine zugeordnete Messeinrichtung aufweist und die einzelnen Messwerte aufgrund eines Lesebefehls einer Steuereinheit ausgelesen werden.

Die US 2010 0239896 A1 beschreibt ein Verfahren zur Messung der Zellspannungen einer Vielzahl von in Reihe geschalteten Batteriezellen.

### Offenbarung der Erfindung

Erfindungsgemäß wird eine Vorrichtung zur Messung der minimalen Zellspannung unter den Zellspannungen einer Vielzahl von in Reihe geschalteten Batteriezellen bereitgestellt, wobei die Vorrichtung eine Vielzahl von in Reihe geschalteten ohmschen Widerständen umfasst, wobei die Vorrichtung derart mit einer Vielzahl von in Reihe geschalteten Batteriezellen verbindbar ist, dass entsprechend den Reihenschaltungen jedem ohmschen Widerstand eine Batteriezelle zugeordnet wird, wobei ein erster ohmscher Widerstand, der allen anderen ohmschen Widerständen in der Reihenschaltung vorangeht, dazu ausgelegt ist, einen der Zellspannung der zugeordneten Batteriezelle entsprechenden Strom zu führen, und wobei jeder ohmsche Widerstand mit Ausnahme des ersten ohmschen Widerstandes dazu ausgelegt ist, den kleineren eines Stromes, der der Zellspannung der zugeordneten Batteriezelle entspricht, und des Stromes, den der in der Reihenschaltung vorangehende ohmsche Widerstand führt, zu führen.

Vorzugsweise weist jeder der ohmschen Widerstände denselben Widerstandswert R auf. Vorzugsweise ist der einer Zellspannung U entsprechende Strom durch (U - ΔU) / R gegeben, wobei ΔU eine vorbestimmte Spannung ist.

In einer bevorzugten Ausführungsform umfasst die Vorrichtung ferner zu jedem der Vielzahl von ohmschen Widerständen einen zugehörigen Transistor und eine zugehörige Referenzspannungsquelle sowie zu jedem der Vielzahl von ohmschen Widerständen mit Ausnahme des ersten Widerstandes eine zugehörige Diode, wobei jeweils die Kathode jeder Diode mit dem positiven Pol einer dem zugehörigen ohmschen Widerstand zugeordneten Batteriezelle verbindbar ist, die Anode jeder Diode mit einem ersten Anschluss des zugehörigen ohmschen Widerstandes verbunden ist, ein zweiter Anschluss jedes ohmschen Widerstandes mit einem ersten Anschluss des zugehörigen Transistors verbunden ist, der Steueranschluss jedes Transistors mit dem positiven Pol der zugehörigen Referenzspannungsquelle verbunden ist, der negative Pol jeder Referenzspannungsquelle mit dem negativen Pol einer dem zugehörigen ohmschen Widerstand zugeordneten Batteriezelle verbindbar ist, ein erster Anschluss des ersten ohmschen Widerstandes mit dem positiven Pol der zugeordneten Batteriezelle verbindbar ist und der erste Anschluss jedes ohmschen Widerstandes mit Ausnahme des ersten ohmschen Widerstandes mit einem zweiten Anschluss des dem in der Reihenschaltung vorangehenden ohmschen Widerstand zugehörigen Transistors verbunden ist. Vorzugsweise sind die Referenzspannungsquellen dazu ausgelegt, jeweils dieselbe Referenzspannung bereitzustellen, und die vorbestimmte Spannung ΔU ist durch diese Referenzspannung gegeben.

Die Vorrichtung kann derart mit einer Vielzahl von in Reihe geschalteten Batteriezellen verbunden sein, dass entsprechend den Reihenschaltungen jedem ohmschen Widerstand eine Batteriezelle zugeordnet ist. Vorzugsweise sind die Batteriezellen Lithium-Ionen-Batteriezellen.

Erfindungsgemäß werden ferner eine Batteriemanagementeinheit mit einer erfindungsgemäßen Vorrichtung, eine Batterie mit einer erfindungsgemäßen Vorrichtung oder einer erfindungsgemäßen Batteriemanagementeinheit sowie ein Kraftfahrzeug, insbesondere ein elektrisches Kraftfahrzeug, mit einer erfindungsgemäßen Batterie bereitgestellt.

Des Weiteren stellt die Erfindung ein Verfahren zur Messung der minimalen Zellspannung unter den Zellspannungen einer Vielzahl von in Reihe geschalteten Batteriezellen bereit, wobei ein erster Strom hervorgerufen wird, der der Zellspannung einer ersten Batteriezelle entspricht, die allen anderen Batteriezellen in der Reihenschaltung vorangeht, und wobei weitere Ströme hervorgerufen werden, wobei jeder weitere Strom einer Batteriezelle zugeordnet ist und wobei jeder weitere Strom der kleinere eines Stromes, der der Zellspannung der zugeordneten Batteriezelle entspricht, und des der der zugeordneten Batteriezelle in der Reihenschaltung vorangehenden Batteriezelle zugeordneten Stromes ist.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein Schaltbild einer Vorrichtung zur Einzelüberwachung der Spannung von Batteriezellen gemäß dem Stand der Technik,
Figur 2 ein Diagramm zur Darstellung des Prinzips der Erfindung,
Figur 3 ein Ausführungsbeispiel einer erfindungsgemäßen Vorrichtung zur Messung einer minimalen Zellspannung, und
Figur 4 ein Ausführungsbeispiel einer Auswerteschaltung für die Vorrichtung von Figur 3.

### Ausführungsformen der Erfindung

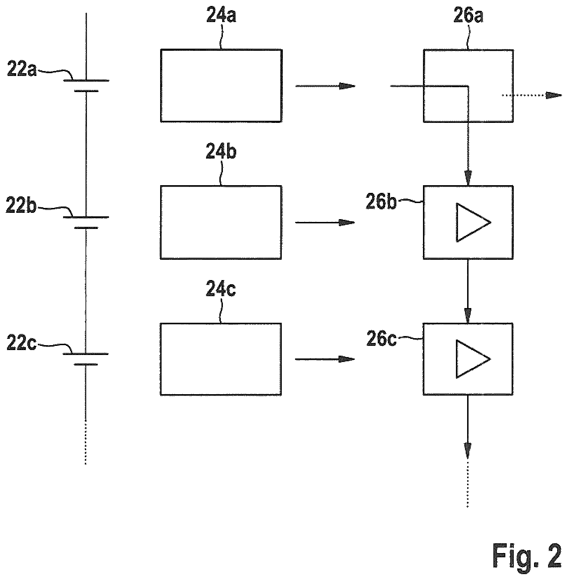

In Figur 2 ist das Prinzip dargestellt, nach dem erfindungsgemäß die minimale Zellspannung unter den Zellspannungen einer Vielzahl von in Reihe geschalteten Batteriezellen ermittelt wird. Die zu überwachende Batterie umfasst eine Reihe von Batteriezellen 22a, 22b, 22c, .... In einem Erfassungsschritt 24a wird die Zellspannung der Batteriezelle 22a erfasst. In Schritt 26a wird die erfasste Zellspannung unverändert weitergegeben; dieser Schritt bezieht sich nur auf die erste der Batteriezellen. In einem Erfassungsschritt 24b wird die Zellspannung der Batteriezelle 22b erfasst. In einem Vergleichsschritt 26b wird die erfasste Zellspannung der Batteriezelle 22b mit der in Schritt 26a weitergegebenen Zellspannung verglichen, und die kleinere der beiden Spannungen wird ausgegeben. Ebenso wird in einem Erfassungsschritt 24c die Zellspannung der Batteriezelle 22c erfasst und in einem Vergleichsschritt 26c die erfasste Zellspannung der Batteriezelle 22c mit der in Schritt 26b ausgegebenen Zellspannung verglichen, und die kleinere der beiden Spannungen wird ausgegeben. Durch Fortsetzung dieses Verfahrens für sämtliche Batteriezellen wird die kleinste der Zellspannungen aller Batteriezellen 22a, 22b, 22c, ... bestimmt.

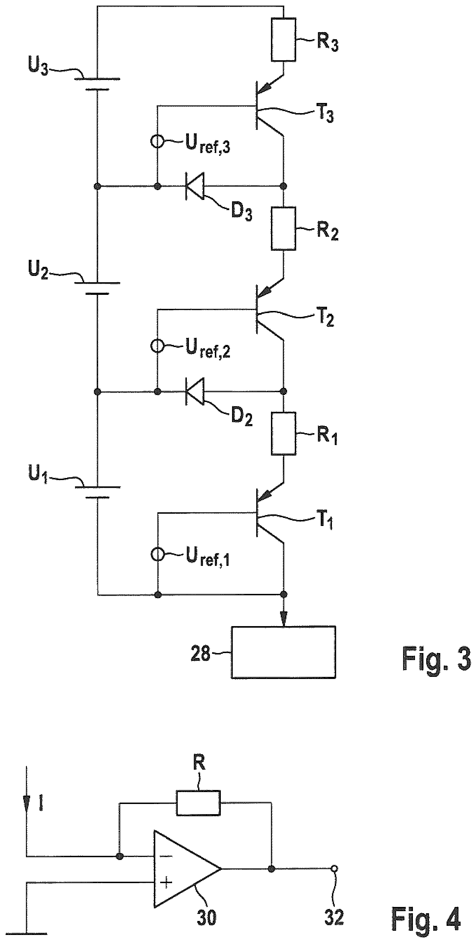

In Figur 3 ist ein Ausführungsbeispiel einer erfindungsgemäßen Vorrichtung zur Messung der minimalen Zellspannung unter den Zellspannungen einer Vielzahl von in Reihe geschalteten Batteriezellen gezeigt. In diesem Ausführungsbeispiel umfasst die Reihenschaltung drei Batteriezellen; die Erfindung ist jedoch nicht auf diese Anzahl von Batteriezellen beschränkt. Die Zellspannungen U₁, U₂, U₃ werden über Dioden D₂ und D₃ abgegriffen, die als idealisierte Dioden mit verschwindender Flussspannung betrachtet werden. Über ohmsche Widerstände R₁, R₂, R₃ und Transistoren T₁, T₂, T₃ werden die Zellspannungen jeweils mit Referenzspannungsquellen U_{ref,1}, U_{ref,2}, U_{ref,3} in Beziehung gesetzt, wobei die Transistoren T₁, T₂, T₃ als idealisierte Transistoren, beispielsweise PNP-Transistoren mit verschwindender Basis-Emitter-Spannung betrachtet werden. Unter der Basis-Emitter-Spannung eines Transistors wird dabei diejenige Spannung verstanden, die zwischen Basis und Emitter des Transistors anliegt, wenn ein Strom zwischen Emitter und Kollektor fließt; diese Spannung ist näherungsweise unabhängig von dem zwischen Emitter und Kollektor fließenden Strom. Idealerweise haben sämtliche ohmschen Widerstände R₁, R₂, R₃ denselben Widerstandswert R, und sämtliche Referenzspannungsquellen U_{ref,1}, U_{ref,2}, U_{ref,3} stellen dieselbe Spannung U_{ref} bereit.

An dem ohmschen Widerstand R₃ liegt bei dem beschriebenen idealisierten Verhalten der Bauteile die Spannung U₃ - U_{ref} an, so dass ein Strom I₃ = (U₃ - U_{ref}) / R fließt. Dieser Strom fließt weiter über den ohmschen Widerstand R₂, so dass an diesem höchstens die Spannung R I₃ = U₃ - U_{ref} abfällt. Ist diese Spannung kleiner als die Differenz U₂ - U_{ref}, so sperrt die Diode D₃, und durch den ohmschen Widerstand fließt ausschließlich der Strom I₂ = I₃. Ist sie dagegen größer, das heißt, gilt U₃ - U_{ref} > U₂ - U_{ref} und damit U₂ < U₃, so wird die Diode D₃ leitend, und an dem ohmschen Widerstand R₂ liegt die Spannung U₂ - U_{ref} an, so dass ein Strom I₂ = (U₂ - U_{ref}) / R fließt. In beiden Fällen fließt also ein Strom I₂, der der kleineren der beiden Spannungen U₂ und U₃ entspricht, das heißt I₂ = (min (U₂, U₃) - U_{ref}) / R.

Entsprechendes gilt für die Diode D₂ und den ohmschen Widerstand R₁, so dass durch den ohmschen Widerstand R₁ der Strom I₁ = (min (U₁, min (U₂, U₃)) - U_{ref}) / R = (min (U₁, U₂, U₃) - U_{ref}) / R fließt und an diesem die Spannung min (U₁, U₂, U₃) - U_{ref} abfällt. Der Strom durch T₁, der der minimalen Zellspannung min (U₁, U₂, U₃) entspricht, kann mittels einer Auswerteschaltung 28 ausgewertet werden.

Figur 4 zeigt ein Ausführungsbeispiel einer solchen Auswerteschaltung. Der auszuwertende Strom I wird dem invertierenden Eingang eines Operationsverstärkers 30 zugeführt, der über einen ohmschen Widerstand R gegengekoppelt ist. Der nicht invertierende Eingang des Operationsverstärkers 30 ist geerdet, und der Ausgang des Operationsverstärkers 30 ist mit einem Anschluss 32 verbunden, an dem das Messsignal ausgelesen werden kann.

In einer weiteren Ausführungsform der Erfindung können die idealisierten Bauelemente durch aktive Gleichrichter- und Verstärkerschaltungen ersetzt werden, um das beschriebene Verhalten zu erreichen.

Die oben beschriebene Vorrichtung kann als Teil einer Batteriemanagementeinheit eingesetzt werden, die die minimale Zellspannung der Batteriezellen einer Batterie überwacht und die Batteriezellen gegen Tiefentladung schützt. Eine solche Batteriemanagementeinheit kann als Teil einer Batterie, insbesondere einer in einem Kraftfahrzeug eingesetzten Batterie, verwendet werden.

## Patentansprüche

1. Vorrichtung zur Messung der minimalen Zellspannung unter den Zellspannungen (U₁, U₂, U₃) einer Vielzahl von in Reihe geschalteten Batteriezellen, wobei die Vorrichtung eine Vielzahl von in Reihe geschalteten ohmschen Widerständen (R₁, R₂, R₃) umfasst, wobei die Vorrichtung derart mit einer Vielzahl von in Reihe geschalteten Batteriezellen verbindbar ist, dass entsprechend den Reihenschaltungen jedem ohmschen Widerstand (R₁, R₂, R₃) eine Batteriezelle zugeordnet wird, und wobei ein erster ohmscher Widerstand (R₃), der allen anderen ohmschen Widerständen (R₁, R₂) in der Reihenschaltung vorangeht, dazu ausgelegt ist, einen der Zellspannung (U₃) der zugeordneten Batteriezelle entsprechenden Strom zu führen, **dadurch gekennzeichnet, dass**
jeder ohmsche Widerstand (R₁, R₂, R₃) mit Ausnahme des ersten ohmschen Widerstandes (R₃) dazu ausgelegt ist, den kleineren eines Stromes, der der Zellspannung (U₁, U₂) der zugeordneten Batteriezelle entspricht, und des Stromes, den der in der Reihenschaltung vorangehende ohmsche Widerstand (R₂, R₃) führt, zu führen.

2. Vorrichtung nach Anspruch 1, wobei jeder der ohmschen Widerstände (R₁, R₂, R₃) denselben Widerstandswert R aufweist.

3. Vorrichtung nach Anspruch 2, wobei der einer Zellspannung (U) entsprechende Strom durch [U-ΔU] / R gegeben ist, wobei ΔU eine vorbestimmte Spannung ist.

4. Vorrichtung nach einem der vorangehenden Ansprüche, wobei die Vorrichtung ferner zu jedem der Vielzahl von ohmschen Widerständen (R₁, R₂, R₃) einen zugehörigen Transistor (T₁, T₂, T₃) und eine zugehörige Referenzspannungsquelle (U_{ref,1}, U_{ref,2}, U_{ref,3}) sowie zu jedem der Vielzahl von ohmschen Widerständen (R₁, R₂) mit Ausnahme des ersten ohmschen Widerstandes (R₃) eine zugehörige Diode (D₂, D₃) umfasst, wobei jeweils die Kathode jeder Diode (D₂, D₃) mit dem positiven Pol einer dem zugehörigen ohmschen Widerstand (R₁, R₂) zugeordneten Batteriezelle verbindbar ist, die Anode jeder Diode (D₂, D₃) mit einem ersten Anschluss des zugehörigen ohmschen Widerstandes (R₁, R₂) verbunden ist, ein zweiter Anschluss jedes ohmschen Widerstandes (R₁, R₂, R₃) mit einem ersten Anschluss des zugehörigen Transistors (T₁, T₂, T₃) verbunden ist, der Steueranschluss jedes Transistors (T₁, T₂, T₃) mit dem positiven Pol der zugehörigen Referenzspannungsquelle (U_{ref,1}, U_{ref,2}, U_{ref,3}) verbunden ist, der negative Pol jeder Referenzspannungsquelle (U_{ref,1}, U_{ref,2}, U_{ref,3}) mit dem negativen Pol einer dem zugehörigen ohmschen Widerstand (R₁, R₂, R₃) zugeordneten Batteriezelle verbindbar ist, ein erster Anschluss des ersten ohmschen Widerstandes (R₃) mit dem positiven Pol der zugeordneten Batteriezelle verbindbar ist und der erste Anschluss jedes ohmschen Widerstandes (R₁, R₂) mit Ausnahme des ersten ohmschen Widerstandes (R₃) mit einem zweiten Anschluss des dem in der Reihenschaltung vorangehenden ohmschen Widerstand (R₂, R₃) zugehörigen Transistors (T₂, T₃) verbunden ist.

5. Vorrichtung nach Anspruch 4, wobei die Referenzspannungsquellen (U_{ref,1}, U_{ref,2}, U_{ref,3}) dazu ausgelegt sind, jeweils dieselbe Referenzspannung bereitzustellen, und die vorbestimmte Spannung (ΔU) durch diese Referenzspannung gegeben ist.

6. Vorrichtung nach einem der vorangehenden Ansprüche, wobei die Vorrichtung ferner eine Auswerteschaltung (28) umfasst, die einen über einen Widerstand (R) gegengekoppelten Operationsverstärker (30) umfasst, dessen invertierender Eingang mit dem zweiten Anschluss des dem letzten ohmschen Widerstand in der Reihenschaltung zugehörigen Transistors (T₁) verbunden ist, dessen nicht invertierender Eingang geerdet ist und dessen Ausgang mit einem Messanschluss (32) verbunden ist.

7. Vorrichtung nach einem der vorangehenden Ansprüche, wobei die Vorrichtung derart mit einer Vielzahl von in Reihe geschalteten Batteriezellen verbunden ist, dass entsprechend den Reihenschaltungen jedem ohmschen Widerstand (R₁, ..., Rₙ) eine Batteriezelle zugeordnet ist.

8. Batteriemanagementeinheit mit einer Vorrichtung nach Anspruch 7.

9. Batterie mit einer Vorrichtung nach 7 oder einer Batteriemanagementeinheit nach Anspruch 8.

10. Kraftfahrzeug, insbesondere elektrisches Kraftfahrzeug, mit einer Batterie nach Anspruch 9.

11. Verfahren zur Messung der minimalen Zellspannung unter den Zellspannungen (U₁, U₂, U₃) einer Vielzahl von in Reihe geschalteten Batteriezellen, wobei ein erster Strom hervorgerufen wird, der der Zellspannung (U₃) einer ersten Batteriezelle entspricht, die allen anderen Batteriezellen in der Reihenschaltung vorangeht, **dadurch gekennzeichnet, dass** weitere Ströme hervorgerufen werden, wobei jeder weitere Strom einer Batteriezelle zugeordnet ist und wobei jeder weitere Strom der kleinere eines Stromes, der der Zellspannung (U₁, U₂, U₃) der zugeordneten Batteriezelle entspricht, und des der der zugeordneten Batteriezelle in der Reihenschaltung vorangehenden Batteriezelle zugeordneten Stromes ist.

## Claims

1. Device for measuring the minimum cell voltage among the cell voltages (U₁, U₂, U₃) of a plurality of series-connected battery cells, wherein the device comprises a plurality of series-connected ohmic resistors (R₁, R₂, R₃), wherein the device can be connected to a plurality of series-connected battery cells in such a manner, that a battery cell is allocated to each ohmic resistor (R₁, R₂, R₃) according to the series connections, and wherein a first ohmic resistor (R₃) that precedes all of the other ohmic resistors (R₁, R₂) in the series connection is embodied for the purpose of conducting a current that corresponds to the cell voltage (U₃) of the allocated battery cell, **characterized in that**
each ohmic resistor (R₁, R₂, R₃), with the exception of the first ohmic resistor (R₃), is embodied for the purpose of conducting whichever current is the smaller: either a current that corresponds to the cell voltage (U₁, U₂) of the allocated battery cell or the current that is conducted by the ohmic resistor (R₂, R₃) in the series connection.

2. Device according to Claim 1, wherein each of the ohmic resistors (R₁, R₂, R₃) comprises the same resistance value R.

3. Device according to Claim 2, wherein the current which corresponds to a cell voltage (U) is given as [U-Δ]/R, wherein ΔU is a predefined voltage.

4. Device according to any one of the preceding claims, wherein the device comprises, in addition to each of the plurality of ohmic resistors (R₁, R₂, R₃), an associated transistor (T₁, T₂, T₃) and an associated reference voltage source (U_{ref,1}, U_{ref,2}, U_{ref,3}) and, in addition to each of the plurality of ohmic resistors (R₁, R₂) with the exception of the first ohmic resistor (R₃), an associated diode (D₂, D₃), wherein in each case the cathode of each diode (D₂, D₃) can be connected to the positive pole of a battery cell that is allocated to the associated ohmic resistor (R₁, R₂), the anode of each diode (D₂, D₃) is connected to a first connector of the associated ohmic resistor (R₁, R₂), a second connector of each ohmic resistor (R₁, R₂, R₃) is connected to a first connector of the associated transistor (T₁, T₂, T₃), the base connector of each transistor (T₁, T₂, T₃) is connected to the positive pole of the associated reference voltage source (U_{ref,1}, U_{ref,2}, U_{ref,3}), the negative pole of each reference voltage source (U_{ref,1}, U_{ref,2}, U_{ref,3}) can be connected to the negative pole of a battery cell that is allocated to an associated ohmic resistor (R₁, R₂, R₃), a first connector of the first ohmic resistor (R₃) can be connected to the positive pole of the allocated battery cell and the first connector of each ohmic resistor (R₁, R₂) with the exception of the first ohmic resistor (R₃) is connected to a second connector of the transistor (T₂, T₃) that is associated with the series-connected preceding ohmic resistor (R₂, R₃).

5. Device according to Claim 4, wherein the reference voltage sources (U_{ref,1}, U_{ref,2}, U_{ref,3}) are embodied in each case to provide the same reference voltage, and the predefined voltage (ΔU) is given by way of this reference voltage.

6. Device according to any one of the preceding claims, wherein the device additionally comprises an evaluation circuit (28) that comprises an operational amplifier (30) that is subject to negative feedback current by way of an ohmic resistor (R), the inverting input of said operational amplifier is connected to the second connector of the transistor (T₁) that is associated with the last series-connected ohmic resistor, the non-inverting input of said transistor is earthed and the output of said transistor is connected to a test port (32).

7. Device according to any one of the preceding claims, wherein the device is connected to a plurality of series-connected battery cells in such a manner that a battery cell is allocated to each ohmic resistor (R₁,..., Rₙ) according to the series connections.

8. Battery management unit having a device according to Claim 7.

9. Battery having a device according to 7 or a battery management unit according to Claim 8.

10. Motor vehicle, in particular an electric motor vehicle, having a battery according to Claim 9.

11. Method for measuring the minimum cell voltage among the cell voltages (U₁, U₂, U₃) of a plurality of series-connected battery cells, wherein a first current is produced that corresponds to the cell voltage (U₃) of a first battery cell that precedes all other battery cells in the series connection, **characterized in that** further currents are produced, wherein each further current is allocated to a battery cell and wherein each further current is whichever is the smaller current: either a current that corresponds to the cell voltage (U₁, U₂, U₃) of the associated battery cell or the current that is allocated to the associated battery cell in the series-connected preceding battery cell.

## Revendications

1. Dispositif permettant de mesurer la tension d'élément minimale parmi les tensions d'élément (U₁, U₂, U₃) d'une pluralité d'éléments de batterie connectés en série, dans lequel le dispositif comprend une pluralité de résistances ohmiques (R₁, R₂, R₃) connectées en série, dans lequel le dispositif peut être raccordé à une pluralité d'éléments de batterie connectés en série de telle manière qu'un élément de batterie soit associé à chaque résistance ohmique (R₁, R₂, R₃) conformément aux connexions en série, et dans lequel une première résistance ohmique (R₃) précédant toutes les autres résistances ohmiques (R₁, R₂) dans la connexion en série est configurée pour conduire un courant correspondant à la tension d'élément (U₃) de l'élément de batterie associé,
**caractérisé en ce que** chaque résistance ohmique (R₁, R₂, R₃) à l'exception de la première résistance ohmique (R₃) est configurée pour conduire le plus faible d'un courant correspondant à la tension d'élément (U₁, U₂) de l'élément de batterie associé et du courant que conduit la résistance ohmique (R₂, R₃) précédent dans la connexion en série.

2. Dispositif selon la revendication 1, dans lequel chacune des résistances ohmiques (R₁, R₂, R₃) présente la même valeur de résistance R.

3. Dispositif selon la revendication 2, dans lequel le courant correspondant à une tension d'élément (U) est donné par [U-ΔU]/R, où ΔU est une tension prédéterminée.

4. Dispositif selon l'une quelconque des revendications précédentes, dans lequel le dispositif comprend, en plus de chacune de la pluralité de résistances ohmiques (R₁, R₂, R₃), un transistor correspondant (T₁, T₂, T₃) et une source de tension de référence correspondante (U_{ref,1}, U_{ref,2}, U_{ref,3}) et, en plus de chacune de la pluralité de résistances ohmiques (R₁, R₂) à l'exception de la première résistance ohmique (R₃), une diode correspondante (D₂, D₃), dans lequel la cathode de chaque diode (D₂, D₃) peut être respectivement raccordée au pôle positif d'un élément de batterie associé à la résistance ohmique concernée (R₁, R₂), l'anode de chaque diode (D₂, D₃) est raccordée à une première borne de la résistance ohmique correspondante (R₁, R₂), une deuxième borne de chaque résistance ohmique (R₁, R₂, R₃) est raccordée à une première borne du transistor correspondant (T₁, T₂, T₃), la borne de commande de chaque transistor (T₁, T₂, T₃) est raccordée au pôle positif de la source de tension de référence correspondante (U_{ref,1}, U_{ref,2}, U_{ref,3}) , le pôle négatif de chaque source de tension de référence (U_{ref,1}, U_{ref,2}, U_{ref,3}) peut être raccordé au pôle négatif d'un élément de batterie associé à la résistance ohmique correspondante (R₁, R₂, R₃), une première borne de la première résistance ohmique (R₃) peut être raccordée au pôle positif de l'élément de batterie associé, et la première borne de chaque résistance ohmique (R₁, R₂) à l'exception de la première résistance ohmique (R₃) est raccordée à une deuxième borne du transistor (T₂, T₃) correspondant à la résistance ohmique (R₂, R₃) précédente dans la connexion en série.

5. Dispositif selon la revendication 4, dans lequel les sources de tension de référence (U_{ref,1}, U_{ref,2}, U_{ref,3}) sont configurées pour fournir respectivement la même tension de référence, et la tension prédéterminée (ΔU) est donnée par ladite tension de référence.

6. Dispositif selon l'une quelconque des affirmations précédentes, dans lequel le dispositif comprend en outre un circuit d'évaluation (28) comprenant un amplificateur opérationnel (30) couplé en contre-réaction par l'intermédiaire d'une résistance (R), dont l'entrée inverseuse est raccordée à la deuxième borne du transistor (T₁) correspondant à la dernière résistance ohmique dans la connexion en série, dont l'entrée non inverseuse est mise à la terre et dont la sortie est raccordée à une borne de mesure (32).

7. Dispositif selon l'une quelconque des revendications précédentes, dans lequel le dispositif est raccordé à une pluralité d'éléments de batterie connectés en série de telle manière qu'un élément de batterie soit associé à chaque résistance ohmique (R₁, ..., Rₙ) conformément aux connexions en série.

8. Unité de gestion de batterie comportant un dispositif selon la revendication 7.

9. Batterie comportant un dispositif selon 7 ou une unité de gestion de batterie selon la revendication 8.

10. Véhicule à moteur, en particulier véhicule à moteur électrique, comportant une batterie selon la revendication 9.

11. Procédé permettant de mesurer la tension d'élément minimale parmi des tensions d'élément (U₁, U₂, U₃) d'une pluralité d'éléments de batterie connectés en série, dans lequel un premier courant est généré, celui-ci correspondant à la tension d'élément (U₃) d'un premier élément de batterie précédant tous les autres éléments de batterie dans la connexion en série, **caractérisé en ce que** d'autres courants sont générés, dans lequel chaque autre courant est associé à un élément de batterie, et dans lequel chaque autre courant est le plus petit d'un courant correspondant à la tension d'élément (U₁, U₂, U₃) de l'élément de batterie associé et du courant associé à l'élément de batterie précédant l'élément de batterie associé dans la connexion en série.
